Europäisches Patentamt

European Patent Office

Office européen des brevets

(19)

(11) Veröffentlichungsnummer: **0 070 796**
**B2**

(12) **NEUE EUROPÄISCHE PATENTSCHRIFT**

(45) Veröffentlichungstag der neuen Patentschrift:
27.12.90

(21) Anmeldenummer: 82810271.5

(22) Anmeldetag: 24.06.82

(51) Int. Cl.⁵: **H 03 L 1/02,** H 03 K 17/95,
H 03 H 5/10

(54) **Verfahren zur Kompensation der Temperaturabhängigkeit der Schwingamplitude eines durch einen Generator angeregten Schwingkreises, nach diesem Verfahren kompensierter Oszillator und Verwendung desselben.**

(30) Priorität: 17.07.81 CH 4702/81

(43) Veröffentlichungstag der Anmeldung:
26.01.83 Patentblatt 83/04

(45) Bekanntmachung des Hinweises auf die
Patenterteilung:
13.02.85 Patenblatt 85/07

(45) Bekanntmachung des Hinweises auf die
Entscheidung über den Einspruch:
27.12.90 Patentblatt 90/52

(84) Benannte Vertragsstaaten:
AT BE DE FR GB IT NL SE

(56) Entgegenhaltungen:
DE-A-1 589 826
DE-A-2 356 783
ELEKTRONIK, Band 19, Nr. 3, März 1970, Seite
88, Müchen (DE);

ELEKTRONIC TECHNOLOGY, Band 39, Nr. 9,
September 1962, Seiten 347-352, London (GB);

Die Akte enthält technische Angaben, die nach
dem Eingang der Anmeldung eingereicht
wurden und die nicht in dieser Patentschrift
enthalten sind.

(73) Patentinhaber: CONTRINEX S.A.
CH-1752 Matran (CH)
(73) Patentinhaber: Siemens Aktiengesellschaft
Wittelsbacherplatz 2
D-8000 München 2 (DE)

(72) Erfinder: Heimlicher, Peter
Klein-Schönberg 112
CH-1700 Fribourg (CH)

(74) Vertreter: Steiner, Martin et al
c/o AMMANN PATENTANWÄLTE AG BERN
Schwarztorstrasse 31
CH-3001 Bern (CH)

## Beschreibung

Die vorliegende Erfindung betrifft ein Verfahren zur Kompensation der Temperaturabhängigkeit der Schwingamplitude eines durch einen Generator angeregten Schwingkreises, einen nach diesem Verfahren kompensierten Oszillator und eine Verwendung desselben.

Oszillatoren, welche einen LC-Schwingkreis aufweisen, werden z.B. in induktiven Näherungsschaltern verwendet, wobei die Annäherung eines sog. Meßplättchens eine Dämpfung der durch den Oszillator erzeugte Schwingung hervorruft. Dadurch nimmt die Amplitude des Ausgangssignals des Oszillators ab und steuert z.B. einen Schwellenwertdetektor, der ein nutzbares Ausgangssignal des Näherungsschalters liefert.

Der Hauptnachteil handelsüblicher induktiver Näherungsschalter besteht in ihrem relativ kleinen Schaltabstand. Einer Erhöhung dieses Schaltabstandes steht die Temperaturabhängigkeit der verwendeten Oszillator-Schwingkreiskombination entgegen, die bei erhöhtem Schaltabstand zu einem normalerweise nicht akzeptierbaren Temperaturkoeffizienten desselben führt.

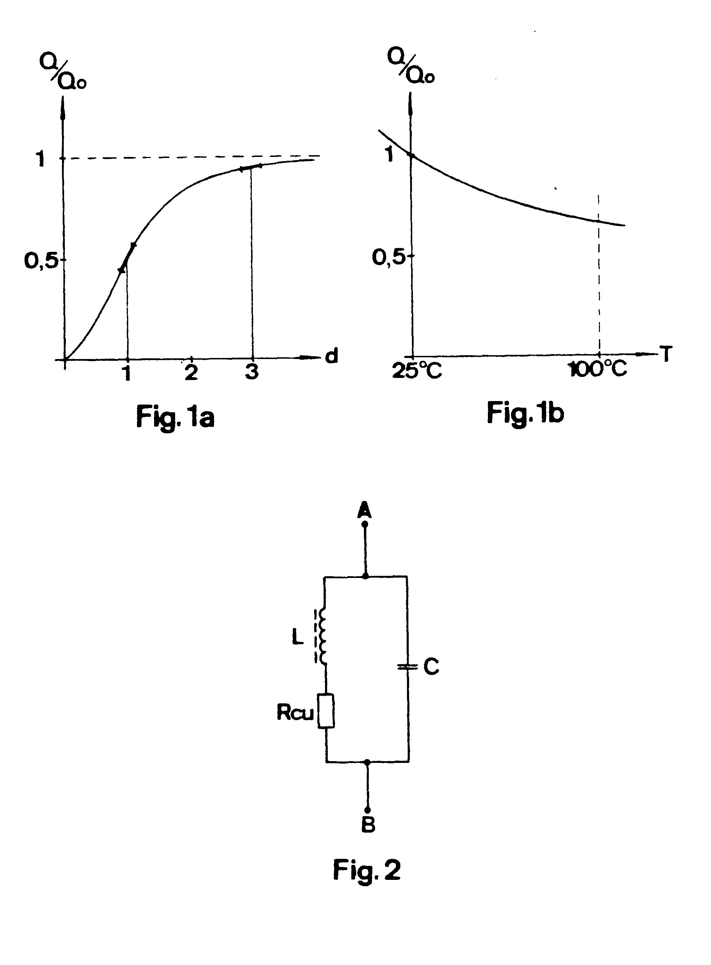

Fig. 1a zeigt das Verhalten der relativen Schwingkreisgüte Q/Qo in Funktion der Distanz d (Schaltabstand) des Meßplättchens eines induktiven Näherungsschalters. Mit zunehmendem Schaltabstand sinkt die nutzbare Änderung der relativen Schwingkreisgüte Q/Qo rasch auf einen sehr kleinen Wert. Ist der normale Arbeitsbereich so gewählt, daß für einen gegebenen Schaltabstand die relative Schwingkreisgüte 50% beträgt, so zeigt die Kurve von Fig. 1a, daß sich die relative Schwingkreisgüte auf ca. 3% für einen dreimal größeren Schaltabstand reduziert.

Der Einfluß der Umgebungstemperatur auf die relative Schwingkreisgüte ist in Fig. 1b wiedergegeben, welche zeigt, daß das Verhältnis Q/Qo mit steigender Temperatur abnimmt. Ein Vergleich mit Fig. 1a läßt erkennen, daß bei größeren Schaltabständen der Temperatureinfluß auf Q/Qo rasch größer wird als die durch das Meßplättchen bewirkte Änderung.

Es ist aus der DE—A—1 589 826 eine Spulenanordnung mit kleiner Temperaturabhängigkeit der Güte bekannt. Die Temperaturkompensation der Güte der Spule wird erzielt, indem diese Spule als Primärwicklung eines Transformators geschaltet ist, dessen Sekundärkreis kurzgeschlossen ist. Der spezifische Widerstand des Leitmaterials der Sekundärwicklung hat eine Temperaturabhängigkeit gleichen Vorzeichens wie der spezifische Widerstand des Leitermaterials der Primärwicklung. Der Kopplungsfaktor sowie das Verhältnis des ohmschen Wicklungswiderstandes zum induktiven Widerstand dieser Wicklung werden so gewählt, daß die Güte, die an den Anschlüssen der Primärwicklung auftritt, eine geringere Temperaturabhängigkeit hat, als die Güte der Primärwicklung allein. Jedoch braucht diese Güte-Kompensation eine zweite, kurzgeschlossene Wicklung, die als Sekundärwicklung eines Transformators geschaltet ist und die Kompensation, welche nicht vollständig ist, wird durch eine relativ große Verminderung des Gütefaktors erzielt.

Es ist daher Aufgabe der vorliegenden Erfindung, ein Verfahren anzugeben, welches diese Nachteile nicht aufweist, und das die Temperaturabhängigkeit der Schwingamplitude eines durch einen Generator angeregten Schwingkreises ohne Beeinflussung seines Gütefaktors, wesentlich reduziert, so daß z.B. Näherungsschalter geschaffen werden können, deren Schaltabstand ein Mehrfaches der üblichen betragen kann.

Das erfindungsgemäße Verfahren ist im Anspruch 1 gekennzeichnet.

Dadurch ergibt sich eine nahezu ideale Temperaturkompensation, welche auch immer voll wirksam bleibt, selbst wenn Temperaturgradienten innerhalb der Schaltung vorhanden sind, im Gegensatz zu den sich bei der Verwendung von Kompensationselementen, welche außerhalb der Spule angeschlossen sind, ergebenden Verhältnissen.

Es ist eine weitere Aufgabe der vorliegenden Erfindung einen temperaturkompensierten Oszillator nach dem angegebenen Verfahren zu schaffen.

Der erfindungsgemäße Oszillator ist im Anspruch 3 gekennzeichnet.

Die Erfindung wird nun anhand eines Ausführungsbeispiels mit Hilfe der Zeichnung näher erläutert. Darin zeigt

Fig. 1a das Verhalten der relativen Schwingkreisgüte eines induktiven Annäherungsschalters in Funktion des Schaltabstandes,

Fig. 1b das Verhalten der relativen Schwingkreisgüte eines induktiven Annäherungsschalters in Funktion der Temperatur,

Fig. 2 das Ersatzschaltbild eines LC-Schwingkreises,

Fig. 3a das Schaltbild eines LC-Schwingkreises mit einer bifilar gewickelten Spule,

Fig. 3b das Ersatzschaltbild des Schwingkreises nach Fig. 3a,

Fig. 4 das Schaltbild, welches das Prinzip eines Oszillators gemäß vorliegender Erfindung darstellt, und

Fig. 5 das Schaltbild eines erfindungsgemäßen Oszillators.

Eine Analyse des Schwingkreises nach Fig. 2 ergibt, daß die Schwingkreisgüte bei den für einen Annäherungsschalter in Frage kommenden Materialien und Frequenzen zum überwiegenden Teil durch den Kupferwiderstand $R_{cu}$ der Schwingkreisspule L bestimmt wird. Der Zusammenhang mit dem Gütefaktor Q ergibt sich unter Vernachlässigung anderer Verlustquellen zu:

$$Q = \sqrt{\frac{C}{L}} \cdot \frac{\frac{L}{C} + R_{cu}^2}{R_{cu}} \qquad (1)$$

und, da in der Regel $L/C \gg R_{cu}^2$,

$$Q = \sqrt{\frac{L}{C}} \cdot \frac{1}{R_{cu}} \qquad (2)$$

Q und damit auch der Temperaturkoeffizient von Q sind also für einen gegebenen Schwingkreis umgekehrt proportional zum Kupferwiderstand $R_{cu}$ bzw. dessen Temperaturkoeffizienten, welcher ca. +0,004/°K zwischen 0 und 100°C beträgt. Der Temperaturkoeffizient von Q hat also den relativ hohen Wert von ca. −0,4%/°K.

Um diesen Einfluß der Temperatur zu korrigieren, besteht das Verfahren gemäß vorliegender Erfindung darin, die Temperaturabhängigkeit des spezifischen Widerstandes Rcu des Leitermaterials der Schwingkreisspule zur Steuerung der Amplitude des durch den Generator erzeugten Signales so zu nutzen, daß die Schwingamplitude des Schwingkreises temperaturunabhängig wird. Es ergibt sich dadurch eine praktisch ideale Kompensation, auch wenn Temperaturgradienten innerhalb der Schaltung auftreten.

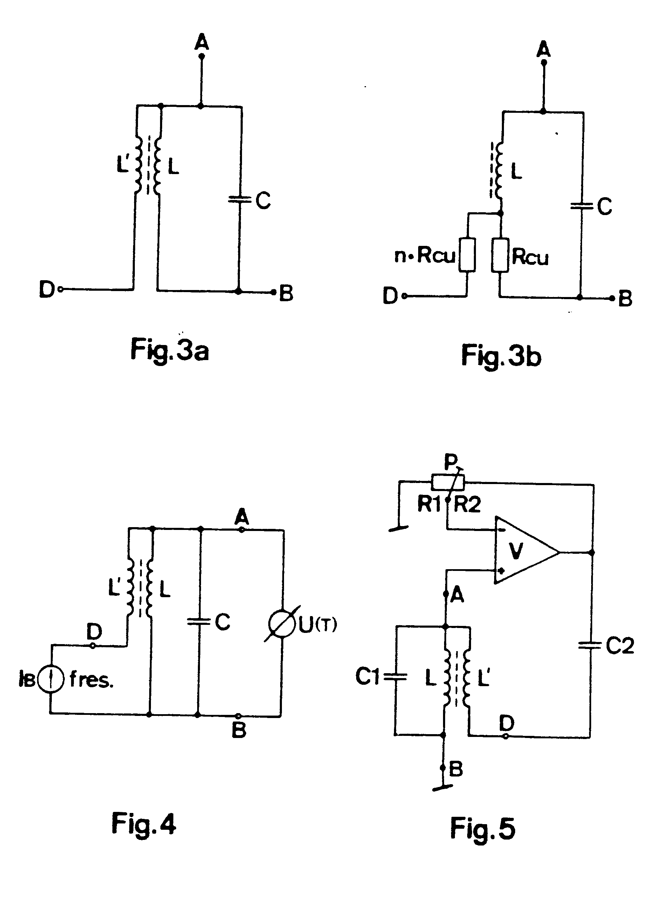

Fig. 3 zeigt, wie auf sehr einfache Weise der Leiterwiderstand der Schwingkreisspule ermittelt werden kann. Die Spule L, welche zwischen den Klemmen A und B angeschlossen ist, wird üblicherweise mit Hochfrequenzlitze als Wicklungsdraht gewickelt. Wird dann z.B. bei dem Anschluß B der Spule ein Litzendraht von den anderen getrennt und separat zu einer Klemme D herausgeführt, so wird die zwischen den Klemmen D und B angeschlossene Spule als bifilar gewickelt angesehen. Dadurch wird der kombinierte Effekt der Induktivitäten L und L' aufgehoben und der Anschluß D erlaubt den Widerstand des Leitermaterials $R_{cu}$ der Spule L zu ermitteln, wie in Fig. 3b angegeben ist.

Wird dann nach Fig. 4 eine konstante Wechselstromquelle $I_B$ mit einer Frequenz $f_{res}$, welche die gleiche ist wie die Resonanzfrequenz des LC-Schwingkreises zwischen die Klemmen D und B angeschlossen, so wird der Schwingkreis auf seiner Resonanzfrequenz angeregt. Die in den Schwingkreis eingekoppelte Spannung ergibt sich zu:

$$U_B = I_B \cdot R_{cu} \qquad (3)$$

Diese eingekoppelte Spannung ist also proportional zum Widerstand des Leitermaterials $R_{cu}$, so daß sie größer wird, wenn die Temperatur steigt, und umgekehrt. Es wurde ferner früher gezeigt, daß der Gütefaktor Q des Schwingkreises umgekehrt proportional zum Widerstand des Leitermaterials $R_{cu}$ verläuft, so daß er kleiner wird wenn die Temperatur steigt, und umgekehrt. Wird aber der Gütefaktor Q kleiner, so wird auch die Spannung am Schwingkreis kleiner und umgekehrt. Steigt dann die Temperatur, so wird die Verminderung der Spannung am Schwingkreis durch die Erhöhung der Spannung am Widerstand des Leitermaterials kompensiert und umgekehrt, wird eine Erhöhung der Spannung am Schwingkreis durch eine Verminderung der Spannung am Widerstand des Leitermaterials der Spule kompensiert. Die zwischen den Punkten A und B meßbare Spannung U(T) ist infolge des gegenläufigen Temperaturkoeffizienten von Q (Beziehung 2) temperaturunabhängig und gegenüber $U_B$ um 90° nacheilend.

Fig. 5 zeigt die Schaltung eines erfindungsgemäßen Oszillators. Um die sehr gute Temperaturstabilität der Schwingamplitude in der beschriebenen Schwingkreisanordnung voll auszunützen, muß auch der Oszillator hohen Anforderungen in bezug auf zeitliche und temperaturmäßige Stabilität der Schleifenverstärkung genügen.

Der Oszillator weist einen Operationsverstärker V auf, dessen invertierender Eingang mit dem Schieber eines Potentiometers P verbunden ist. Das Potentiometer ist zwischen einen Pol der Speisung und den Ausgang des Verstärkers geschaltet und bewirkt eine einstellbare Gegenkopplung für den Verstärker. Der direkte Eingang des Verstärkers ist mit dem LC-Schwingkreis am Punkt A verbunden und der getrennte, separate Anschluß der Spule L', welcher zur Klemme D herausgeführt wird, ist mit dem Ausgang des Verstärkers über einen Kondensator C2 verbunden. Die Schaltung bewirkt, daß der Schwingkreis L, C1 am Punkt A einen negativen Widerstand sieht und schwingt, sofern dieser negative Widerstand kleiner ist als die Impedanz des Schwingkreises. Der Wert des negativen Widerstandes und damit der Einsatzpunkt der Schwingung kann mit dem Potentiometer P eingestellt werden. Der relativ klein zu wählende Kondensator C2 verwandelt durch seine hohe Impedanz den spannungsquellenartigen Ausgang des Verstärkers V praktisch in eine Stromquelle und bewirkt gleichzeitig die erforderliche Phasendrehung um 90°. Das Meßplättchen vor der Spule verändert bei dieser Schaltung den Einsatzpunkt der Schwingung und nicht wie bei herkömmlichen Näherungsschalter-Oszillatoren die Amplitude. Die nachfolgende Auswerteschaltung (nicht beschrieben) kann sich darauf beschränken, das Ein- bzw. Aussetzen der Schwingung in bekannter Art und Weise festzustellen und zu verstärken. Fig. 5 zeigt, daß die Ausführung des Oszillators besonders einfach ist. Durch den erfindungsgemäßen Näherungsschalter kann der Schaltabstand um einen Faktor 3 gegenüber den herkömmlichen Ausführungen größer gemacht werden. Dabei wird ein einwandfreies Funktionieren auch bei größeren Schaltabständen gewährleistet.

**Patentansprüche**

1. Verfahren zur Kompensation der Temperaturabhängigkeit der Schwingamplitude eines durch einen Generator angeregten Schwingkreises, dadurch gekennzeichnet, dass die Temperaturabhängigkeit des spezifischen Widerstandes des Leitermaterials der Schwingkreisspule dazu benützt wird, die Spannungsamplitude des durch den Generator dem Schwingkreis zugeführten Anregungssignals durch den temperaturabhängigen Widerstand des Leitermaterials der Schwingkreisspule zu steuern, wobei der Generator einen konstanten Wechselstrom der gleichen Frequenz wie die des Schwingkreises erzeugt und dessen Strom durch den Leiterwiderstand der Schwingkreisspule fliesst und damit den Schwingkreis anregt.

2. Verfahren nach Anspruch 1, dadurch gekennzeichnet, dass die Schwingkreisspule bifilar ausgeführt ist, so dass deren Leiterwiderstand auch bei angeregtem Schwingkreis ermittelt werden kann.

3. Nach dem Verfahren gemäss Anspruch 1 temperaturkompensierter Oszillator, dadurch gekennzeichnet, dass er einen Schwingkreis (L, L', Cl) aufweist, der mit einem Generator ($I_B$) konstanter Wechselstromamplitude der gleichen Frequenz wie die des Schwingkreis verbunden ist, wobei das dem Schwingkreis zugeführte Anregungssignal durch den temperaturabhängigen Widerstand des Leitermaterials der Schwingkreisspule gesteuert ist.

4. Oszillator nach Anspruch 3, dadurch gekennzeichnet, dass die Schwingkreisspule (L, L') in an sich bekannter Weise eine Hochfrequenzlitze als Wicklungsdraht aufweist, und dass sie, um den Leiterwiderstand (Rcu) der Schwingkreisspule auch bei schwingendem Schwingkreis ermitteln zu können, bifilar ausgeführt ist, indem bei einem Anschluss (B) derselben ein Litzendraht von den anderen getrennt und separat zu einer Klemme (D) herausgeführt wird, wobei eine konstante Wechselstromquelle ($I_B$, C2) mit der genannten Klemme (D) der Schwingkreisspule verbundenen ist, so dass der Schwingkreis angeregt wird und die temperaturkompensierte Schwingkreisspannung an einem Anschluss (A) ausgekoppelt wird.

5. Oszillator nach Anspruch 4, dadurch gekennzeichnet, dass er einen Operationsverstärker (V) aufweist, dessen invertierender Eingang mit dem Schieber eines Potentiometers (P) verbunden ist, welches zwischen den einen Pol der Speisung und den Ausgang des Operationsverstärkers (V) geschaltet ist, dessen direkter Eingang durch den Schwingkreis mit dem einen Pol der Speisung verbunden ist, wobei der auf den Auschluss (D) separat herausgeführte Litzendraht durch einen Kopplungskondensator (C2) mit dem Ausgang des Operationsverstärkers verbunden ist.

6. Oszillator nach Anspruch 5, dadurch gekennzeichnet, dass der Kopplungskondensator (C2) einen relativ kleinen Kapazitätswert aufweist, und dass er durch seine hohe Impedanz den spannungsquellenartigen Ausgang des Operationsverstärkers praktisch in eine Stromquelle zur Anregung des Schwingkreises verwandelt.

7. Verwendung des Oszillators nach Anspruch 3 für einen temperaturkompensierten Näherungsschalter mit einem erhöhten Schaltabstand, wobei ein Messplättchen, welches sich vor der Spule befindet und in Funktion seines Abstandes von der Letzteren den Näherungsschalter steuert, den Einsatzpunkt der Schwingung des Oszillators bestimmt.

## Revendications

1. Procédé de compensation de la dépendance en température de l'amplitude d'oscillation d'un circuit oscillant excité par un générateur, caractérisé en ce que la dépendance en température de la résistance spécifique du matériau conducteur de la bobine oscillatrice est utilisé pour régler par la résistance dépendante de la température du matériau conducteur de la bobine oscillatrice l'amplitude en tension du signal d'excitation délivré par le générateur au circuit oscillant, le générateur produisant un courant alternatif constant de même fréquence que le circuit oscillant et son courant traversant la résistance de conduction de la bobine oscillatrice et excitant ainsi le circuit oscillant.

2. Procédé selon la revendication 1, caractérisé en ce que la bobine oscillatrice est exécutée de manière bifilaire, de sorte que sa résistance de conduction peut aussi être déterminée même lorsque le circuit oscillant est excité.

3. Oscillateur compensé en température selon la procédé de la revendication 1, caractérisé en ce qu'il comprend un circuit oscillant (L, L', Cl) qui est connecté à un générateur ($I_B$) d'amplitude alternative constante de même fréquence que celle du circuit oscillant, le signal d'excitation délivré au circuit oscillant étant réglé par la résistance dépendante en température du matériau conducteur de la bobine oscillatrice.

4. Oscillateur selon la revendication 3, caractérisé en ce que la bobine oscillatrice (L, L') comprend de manière connue un fil torsadé haute fréquence comme fil d'enroulement et en ce qu'elle est exécutée sous forme bifilaire pour déterminer, même lorsque le circuit oscillant est en oscillation, la résistance de conduction (Rcu) de la bobine oscillatrice, en ce qu'à une borne (B) de celle-ci un brin du fil torsadé est séparé des autres et connectée séparément à une borne (D), une source de courant alternatif constant ($I_B$, C2) étant connectée avec la borne mentionnée (D) de la bobine oscillatrice, de sorte que le circuit oscillant est excité et que la tension compensée en température du circuit oscillant est délivrée à une borne (A).

5. Oscillateur selon la revendication 4, caractérisé en ce qu'il comprend un amplificateur opérationnel (V) dont l'entrée qui inverse est reliée avec le curseur d'un potentionmètre (P) connecté entre un pole de l'alimentation et la sortie de l'amplificateur opérationnel (V), dont l'entrée directe est connectée par le circuit oscillant avec un pole de l'alimentation, le brin de fil torsadé relié séparément à la borne (D) étant connecté par un condensateur de couplage (C2) avec la sortie de l'amplificateur opérationnel.

6. Oscillateur selon la revendication 5, caractérisé en ce que le condensateur de couplage (C2) a une capacité de relativement faible valeur et en ce qu'il transforme pratiquement par sa haute impédance la sortie en tension de l'amplificateur opérationnel en une source de courant pour l'excitation du circuit oscillant.

7. Utilisation de l'oscillateur selon la revendication 3 pour un détecteur de proximité compensé en température avec une distance de commutation augmentée, une plaquette de mesure se trouvant devant la bobine commandant en fonction de sa distance à cette dernière le détecteur de proximité et déterminant le point d'enclenchement de l'oscillation de l'oscillateur.

**Claims**

1. Method for compensating the temperature dependence of the amplitude of the oscillation of an oscillating circuit excited by a generator, characterized in that the temperture dependence of the specific resistance of the conductive material of the oscillating coil is utilized for adjusting by the temperature dependent resistance of the conductive material of the oscillating coil the amplitude of the voltage of the excitation signal delivered by the generator to the oscillating circuit, the generator producing a constant alternating current having same frequency as the oscillating circuit and its current flowing through the conductive resistance of the oscillating coil and exciting in this way the oscillating circuit.

2. Method according to claim 1, characterized in that the oscillating coil is realized as a bifilar coil, so that its conductive resistance can be determined, even if the oscillating circuit is excited.

3. Temperature compensated oscillator according to the method of claim 1, characterized in that it comprises an oscillating circuit (L, L', Cl) which is connected to a generator ($I_B$) of constant alternating amplitude of same frequency as the one of the oscillating circuit, the exciting signal delivered to the oscillating circuit being adjusted by the temperature dependent resistance of the conductive material of the oscillating coil.

4. Oscillator according to claim 3, characterized in that the oscillating coil (L, L') comprises in a known manner a high frequency stranded wire as winding wire and in that it is realized as a bifilar coil for determining, even if the oscillating circuit is oscillating, the conductive resistance (Rcu) of the oscillating coil, in that at a terminal (B) of the latter a strand is separated from the other strands and separately connected to a terminal (D), a source of constant alternating current ($I_B$, C2) being connected to the mentioned terminal (D) of the oscillating coil, so that the oscillating circuit is excited and that the temperature compensated voltage of the oscillating circuit is delivered to an output terminal (A).

5. Oscillator according to claim 4, characterized in that it comprises an operational amplifier (V) the inverting input of which is connected with the slider of a potentiometer (P) connected between a pol of the supply and the output of the operational amplifier (V) the direct input of which is connected by the oscillating circuit with a pol of the supply, the strand of the stranded wire separately connected to the terminal (D) being connected by a coupling capacitor (C2) to the output of the operational amplifier.

6. Oscillator according to claim 5, characterized in that the coupling capacitor (C2) has a relatively small capacity and in that it transforms practically by its high impedance the output voltage of the operational amplifier into a current source for exciting the oscillating circuit.

7. Utilization of the oscillator according to claim 3 for a temperature compensated proximity switch with an increased switching distance, a driving plate located in front of the coil controlling as a function of its distance to the latter the proximity switch and determining the switching point of the oscillation of the oscillator.

Fig. 1a

Fig. 1b

Fig. 2

1

Fig.3a

Fig.3b

Fig.4

Fig.5